# EUROPEAN PATENT SPECIFICATION

(11) **EP 4 047 336 B1**
(45) Date of publication and mention of the grant of the patent: **28.08.2024**
(21) Application number: 21157553.5
(22) Date of filing: 17.02.2021
(51) Int. Cl.: G01K 7/42

(54) **METHOD OF GENERATING A THERMAL MODEL OF A SYSTEM COMPRISING AN ELECTRICAL MACHINE**
VERFAHREN ZUR ERZEUGUNG EINES THERMISCHEN MODELLS EINES SYSTEMS MIT EINER ELEKTRISCHEN MASCHINE
PROCÉDÉ DE GÉNÉRATION D'UN MODÈLE THERMIQUE D'UN SYSTÈME COMPRENANT UNE MACHINE ÉLECTRIQUE

(43) Date of publication of application: 24.08.2022
(73) Proprietor: ABB Schweiz AG, 5400 Baden (CH)
(72) Inventor: RÖNNBERG, Kristian, 723 40 Västerås (SE); KAKOSIMOS, Panagiotis, 723 58 Västerås (SE); CHEN, Wenliang, 114 20 Stockholm (SE)
(74) Representative: Kransell & Wennborg KB

(56) References cited:
- WO-A1-2017/041123
- US-A1- 2012 226 483
- US-A1- 2020 341 062

## Description

### TECHNICAL FIELD

The present disclosure generally relates to electrical machines.

### BACKGROUND

Thermal models are used to predict the temperature and heat distribution in electrical machines. By knowing the temperature and heat distribution, monitoring and control of electrical machines may be improved.

Electric machines such as motors are typically operated by drives. Electrical machines furthermore are coupled with mechanical loads such as gears.

A system comprising a motor, a power converter, and load can be described by an integrated thermal model in which the various system components influence each other. It would be desirable to be able to generate an integrated thermal model which provides an accurate estimation of such a system.

US2020341062 A1 discloses a system for thermal management of an electric motor. It uses an augmented thermal circuit model of the electric motor, which relates temperatures of a set of nodes of the thermal circuit model with the temperature measurements at a first subset of nodes and heat losses of heat sources at a second subset of nodes, for joint estimation of the temperatures at the entire set of nodes and values of the heat losses in the second subset of nodes. The system solves the joint estimation using an estimator/observer. The system outputs one or combination of the values of the temperatures of the set of nodes and the values of the heat losses.

US2012226483 A1 discloses motor temperature estimation based on a thermal model. A power source provides electrical energy to a motor, and the motor generates rotational motion from the electrical energy received. The computing device is configured to estimate a temperature of the motor in real time based at least in part on a thermal model of the motor. The thermal model includes a plurality of nodes and at least one thermal resistance. Each node represents a region of the motor, and each thermal resistance represents a heat transfer path between at least two of the nodes. A method includes solving one or more energy balance equations to determine a temperature change at each node and estimating the temperature of the motor in real time based at least in part on the temperature change at each node and at least one of the thermal resistances in the thermal model.

WO2017041123 A1 discloses a method for monitoring a semiconductor module, in particular an LED module, having the following steps: generating a theoretical model (TM) of the semiconductor module, measuring thermal impedances of the semiconductor module, comparing the theoretical model (TM) with measurement values (MW), the theoretical model (TM) being validated using the measurement values (MW), and generating a compact thermal model (KM) for representing a heat flow in the semiconductor module in order to monitor a state of the semiconductor module.

### SUMMARY

In view of the above, a general object of the present disclosure is to provide a method of generating a thermal model for a system comprising an electrical machine connected to another device, which solves or at least mitigates the problems of the prior art.

There is hence according to a first aspect of the present disclosure provided a method of generating, from a first thermal model describing the individual thermal behaviour of an electrical machine and a second thermal model describing the individual thermal behaviour of a device, a composite thermal model describing the thermal behaviour of a system comprising the electrical machine connected to the device, the method comprising: a) connecting at least one geometric entity of one of the first thermal model and the second thermal model to a plurality of geometric entities of the other one of the first thermal model and the second thermal model, each connection comprising at least one of a heat source and a thermal impedance, wherein the first thermal model and the second thermal model connected to each other form an initial composite thermal model, b) comparing measured temperatures with corresponding estimated temperatures obtained from the initial composite thermal model, and in case an estimated temperature deviates with more than a threshold value from a measured temperature, c) adjusting at least one of a thermal impedance and a heat source between a pair of geometric entities connected in step a).

In this way, the connections between the first thermal model and the second thermal model can be determined and an accurate composite thermal model may be obtained for the system comprising the electrical machine and the device. For example, in case a connection in step a) was erroneous, the thermal impedance between two connected geometric entities may be adjusted in step c) to have a magnitude that is infinite so that the connection becomes an open circuit.

The electrical machine may be a motor or a generator.

According to one embodiment in step c) the adjusting is of at least one of the thermal impedance and the heat source connected between a pair of geometric entities for which at least one geometric entity has an estimated temperature that deviates from the corresponding measured temperature with more than the threshold value.

According to one embodiment each thermal impedance comprises at least one of a thermal resistance and a thermal capacitance.

According to one embodiment step a) involves selecting the plurality of geometric entities based on proximity between the physical positions that they represent and the physical position that the at least one geometric entity represents.

According to one embodiment the proximity is a distance below a threshold value.

Thus, in case the physical positions of geometric entities of the first thermal model and the second thermal model are closer than a threshold value, they may be connected in step a). For example, if the device is a power converter which has a surface mounted to the top surface of a stator shell/chassis of the electrical machine, then the geometric entities of the first model and the second model representing these surfaces or volumes may be connected to each other.

According to one embodiment the device is a power converter. The power converter may for example be an inverter.

One embodiment comprises repeating steps b) and c) until all estimated temperatures are within an acceptable range compared to the corresponding measured temperature to obtain the composite thermal model.

If the first thermal model and the second thermal model were ideal thermal models before they were connected in step a) to form the initial composite thermal model, only the thermal impedances and/or heat sources between geometric entities connected in step a) are adjusted in step c).

Parameters associated with other geometric entities than those connected in step a) may according to one embodiment also be adjusted in step c). Thus, one or more parameters of one or more geometric entities of the first thermal model and/or of the second thermal model may be adjusted. These parameters may be thermal impedances. This may be the case if the first thermal model and/or the second thermal model were non-ideal before being integrated to form the initial composite thermal model.

One embodiment comprises using the composite thermal model for monitoring the electrical machine and the device.

According to one embodiment the first thermal model and the second thermal models are one of a lumped-parameter thermal network, LPTN, a finite element method model and a finite volume method model.

According to one embodiment each geometric entity is one of a node, an edge, a face, and a volume.

Each geometric entity may be a discretised geometry of the electrical machine or the device according to the thermal model.

A node is a point location, an edge is a 1D entity, a face is a 2D entity and a volume is a 3D entity.

In an LPTN, nodes can represent a face or a volume of a physical entity, i.e. the electrical machine or device. This depends on how the thermal resistances are formulated.

In a 3D finite element method, FEM, model or finite volume method, FVM, model it is possible to associate a point, edge, face or volume with something in physical space.

The first thermal model and the second thermal model may be the same type of models or they may be different types of model. For example, both the first thermal model and the second thermal model may be LPTNs, or one may be a LPTN and the other may be a FEM or FVM model. In this case, the data from a LPTN node is transferred to a 2D surface or a 3D volume.

One embodiment comprises obtaining the estimated temperatures based on measured electrical machine operating parameters and device operating parameters provided as inputs to the initial composite thermal model.

The electrical machine operating parameters may for example be machine voltages, machine currents and machine speed. The device operating parameters may for example be device voltages and device currents.

There is according to a second aspect of the present disclosure provided a computer program comprising computer code which when executed by processing circuitry of a thermal model generator causes the thermal model generator to perform the method of the first aspect.

There is according to a third aspect of the present disclosure provided a thermal model generator for generating, from a first thermal model describing the individual thermal behaviour of an electrical machine and a second thermal model describing the individual thermal behaviour of a device, a composite thermal model describing the thermal behaviour of a system comprising the electrical machine connected to the device, the thermal model generator comprising: processing circuitry, and a storage medium comprising computer code which when executed by the processing circuitry causes the thermal model generator to perform the method of the first aspect.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 schematically shows an example of a thermal model generator for generating a composite thermal model of an electrical machine connected to a device;
Fig. 2 shows a system comprising an electrical machine and a device in the form of a power converter;
Fig. 3a schematically shows a simple example of a composite thermal model generated by the thermal model generator in Fig. 1; and
Fig. 3b schematically shows another example of a composite thermal model generated by the thermal model generator in Fig. 1.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

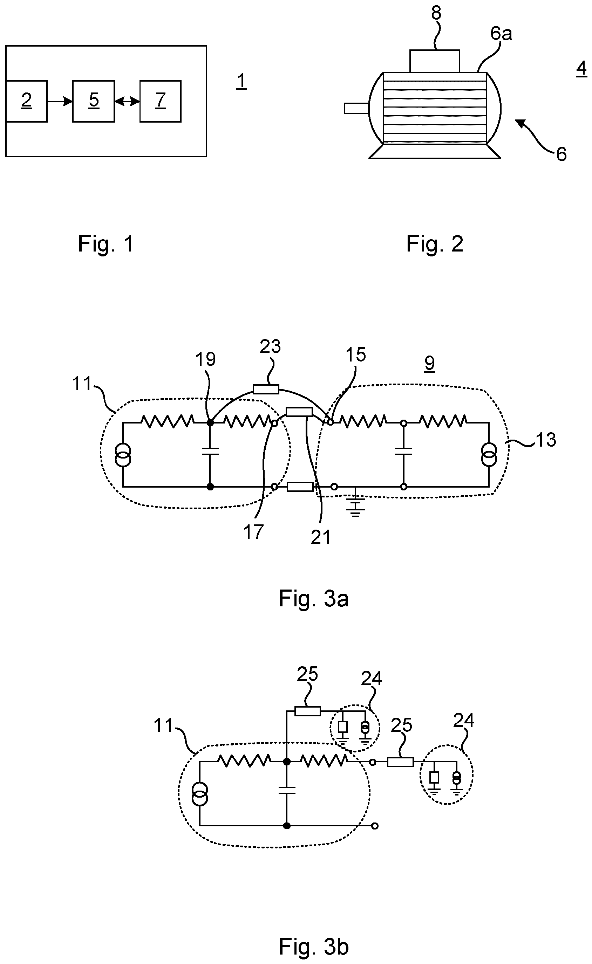

Fig. 1 schematically depicts a block diagram of an example of a thermal model generator 1. The thermal model generator 1 is configured to generate a composite thermal model describing the thermal behaviour of an integrated system comprising an electrical machine connected to a device.

The thermal model generator 1 is configured to generate the composite thermal model from a first thermal model describing the individual thermal behaviour of the electrical machine and a second thermal model describing the individual thermal behaviour of the device.

The first thermal model and the second thermal model may initially be created based on design specifications of the electrical machine and the device, in particular geometric properties, dimensions and material properties.

The first thermal model may be an ideal thermal model, which accurately describes the thermal behaviour of the electrical machine, when the method is commenced. Alternatively, the first thermal model may be a non-ideal thermal model of the electrical machine when the method is commenced.

The second thermal model may be an ideal thermal model, which accurately describes the thermal behaviour of the device, when the method is commenced. Alternatively, the second thermal model may be a non-ideal thermal model of the device when the method is commenced.

The electrical machine may be a motor or a generator.

The device may for example be a power converter such as an inverter, or a drive. A drive comprises a power converter and control circuitry for controlling the power converter and thus the electrical machine.

The electrical machine is provided with a plurality of first temperature sensors configured to measure the temperature in a respective one of a plurality of different locations of the electrical machine.

The first temperature sensors may for example be configured to detect the temperature of the stator windings, the rotor windings, the rotor surface, the stator chassis, and/or the bearings.

The electrical machine may also be provided with other types of sensors for measuring electrical machine operating parameters. Such sensors may be voltage sensors configured to measure machine voltages and current sensors configured to measure machine currents.

The device comprises a plurality of second temperature sensors configured to measure the temperature in a respective one of a plurality of different locations of the device.

The second temperature sensors may for example be configured to detect the temperature of power electronics, and/or the device chassis.

The device may also be provided with other types of sensors for measuring device operating parameters. Such sensors may be voltage sensors configured to measure device voltages and current sensors configured to measure device currents.

The thermal model generator 1 comprises an input unit 2 configured to receive temperature measurement from the first temperature sensors and the second temperature sensors.

The input unit 2 is configured to receive measurements of electrical machine operating parameters and device operating parameters from e.g. voltage sensors and/or current sensors.

The thermal model generator 1 comprises processing circuitry 5 configured to receive the temperature measurements and the measurements of electrical machine operating parameters and device operating parameters from the input unit 2 and to process these measurements.

The thermal model generator 1 may comprise a storage medium 7.

The storage medium 7 may comprise a computer program including computer code which when executed by the processing circuitry 7 causes the thermal model generator 1 to perform the method as disclosed herein.

The processing circuitry 5 may for example use any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations concerning generation of the composite thermal model.

The storage medium 7 may for example be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory.

The composite thermal model is an integrated thermal model taking the thermal influence of the electrical machine on the device and the thermal influence of the device on the electrical machine into account. The first thermal model and the second thermal model hence interact with each other in the composite thermal model.

The first thermal model and the second thermal model may be any of a LPTN, a FEM model or a FVM model. LPTNs, FEM models, FVM models have geometric entities which correspond to physical locations of the electrical machine and the device. The geometric entities may be nodes, edges, faces or volumes, for example depending on the type of the thermal model used.

By means of the first thermal model the temperature can be estimated for the geometric entities that represent physical locations or positions of the electrical machine.

By means of the second thermal model the temperature can be estimated for the geometric entities that represent physical locations or positions of the device.

The thermal model generator 1 is configured to connect one geometric entity of one of the first thermal model and the second thermal model with a plurality of geometric entities of the other one of the first thermal model and the second thermal model via at least one of a thermal impedance and a heat source. There is hence a one-to-several connection between the geometric entities of one of the first thermal model and the second thermal model, with each connection comprising at least one of a thermal impedance and a heat source. The thermal model generator 1 creates an initial composite thermal model in this way.

The composite thermal model is at this point termed "initial" because adjustments of at least one of the connections may be necessary to obtain a composite thermal model which accurately describes the thermal behaviour of the electrical machine and device connected to each other.

The connections between geometric entities of the first thermal model and the second thermal model are made based on the proximity of the physical positions or locations which the geometric entities represent. In case the physical positions are at a distance from each other less than a threshold value, a connection is made between the geometric entities.

The thermal model generator 1 is configured to compare the measured temperatures received from the first temperature sensors and the second temperature sensors with corresponding estimated temperatures of geometric entities of the initial composite thermal model.

The estimated temperatures are determined based on the measured temperatures, the electrical machine operating parameters and the device operating parameters as inputs to the initial composite thermal model.

The thermal model generator 1 is configured to adjust the thermal impedance and/or the heat source of at least one of the connections in case there is a deviation that is larger than a threshold value between a measured temperature and an estimated temperature.

The composite thermal model is formed by reducing the difference between the measured temperatures and the estimated temperatures to an acceptable level. The initial composite thermal model can thus be seen to be optimised, whereby the composite thermal model is obtained.

The thermal impedances and/or heat sources of the connections may have a predefined value in the first iteration of the method. The predefined value may for example be obtained from a database where thermal impedance and/or heat source values of the connections between similar integrated systems have been stored, or they may be zero, close to zero, close to infinity or infinity, or have any value as a starting point.

The thermal impedances and/or heat sources may successively be adjusted as the method is iterated so that all the estimated temperatures converge towards the measured temperatures.

Fig. 2 shows an integrated system of an electrical machine 6 and a device 8 in the form of a power converter. The power converter is in this example mounted to the top of the stator chassis 6a.

Fig. 3a schematically shows a simple example of a composite thermal model 9 in which the first thermal model 11 and the second thermal model 13 are LPTNs. The first thermal model 11 represents the electrical machine 6 and the second thermal model 13 represents the device 8.

The second thermal model has a first node 15 which is connected to a second node 17 and to a third node 19 of the first thermal model 11. The nodes 15, 17, and 19 are examples of geometric entities.

The first connection is between the first node 15 and the second node 17, and the second connection is between the first node 15 and the third node 19. The nodes 15-19 are nodes that represent positions that are physically close in the system 4, the distance being below a threshold value.

The reference number 21 symbolises a thermal impedance and/or a heat source of the first connection between the first node 15 and the second node 17. The reference number 23 symbolises a thermal impedance and/or a heat source of the second connection between the first node 15 and the third node 19.

The thermal impedance(s) and/or heat source(s) of one or more of the connections is/are adjusted in case an estimated temperature in a node deviates with more than a threshold value from the measured temperature measured at a location which corresponds to the node. These nodes may for example be one or more of the three nodes 15, 17, 19 or any other node of the composite thermal model 9.

When the connections between the first thermal model 9 and the second thermal model 13 are initially being made, it is generally not known whether a connection is correct or not, e.g. whether a connection between two nodes should have been made or nor. In the example, it may for instance be found that there should be no connection between the first node 15 and the third node 19. In this case, the thermal impedance 23 may be set to have a magnitude of infinity and thus the connection becomes an open circuit.

In case the first thermal model 11 and the second thermal model 13 were known to be ideal thermal models before connecting them, only the thermal impedances and/or heat sources of the connections between the first thermal model 11 and the second thermal model 13 are adjusted. Otherwise, any thermal resistance or thermal capacitance, or heat source of the initial composite thermal model may be adjusted to obtain more accurate thermal models of the electrical machine and/or the device and thus of the system comprising the electrical machine and the device.

Fig. 3b shows a variation of the method, in which equivalent thermal circuits are used. For example, the full LPTN may be used for the first thermal model 11, but instead of using the LPTN for the second thermal model 13, an equivalent thermal circuit 24 is used. Moreover, an equivalent thermal circuit 25 of the connections may be used for the connections between the first thermal model 11 and the second thermal model 13 or the equivalent thermal circuit 24, respectively. The equivalent thermal circuit 25 may include a thermal impedance and/or a heat source. The equivalent thermal circuit 25 of the connections will thus be connected between several nodes of the first thermal model 11 and the equivalent thermal circuit 24. The equivalent thermal circuit 25 of the connections will in this case be updated by adjusting the individual thermal impedances and/or heat sources of the network if there is a deviation that is greater than a threshold value between a measured temperature and an estimated temperature.

The present method may be used for generating a composite thermal model of more than two individual thermal models. The device may for example be power equipment for controlling the electrical machine, e.g. a drive, and the electrical machine may further be connected to a load having its own thermal model which may be integrated with those of the electrical machine and the device.

## Claims

1. A method of generating, from a first thermal model (11) describing the individual thermal behaviour of an electrical machine (6) and a second thermal model (13) describing the individual thermal behaviour of a device (8), a composite thermal model (9) describing the thermal behaviour of a system (4) comprising the electrical machine (6) connected to the device (8), the method comprising:
a) connecting at least one geometric entity (15, 17, 19) of one of the first thermal model (11) and the second thermal model (13) to a plurality of geometric entities (15, 17, 19) of the other one of the first thermal model (11) and the second thermal model (13), each connection comprising at least one of a heat source and a thermal impedance, wherein the first thermal model (11) and the second thermal model (13) connected to each other form an initial composite thermal model,
b) comparing measured temperatures with corresponding estimated temperatures obtained from the initial composite thermal model, and
in case an estimated temperature deviates with more than a threshold value from a measured temperature,
c) adjusting at least one of a thermal impedance and a heat source between a pair of geometric entities connected in step a).

2. The method as claimed in claim 1, wherein in step c) the adjusting is of at least one of the thermal impedance and the heat source connected between a pair of geometric entities (15, 17, 19) for which at least one geometric entity has an estimated temperature that deviates from the corresponding measured temperature with more than the threshold value.

3. The method as claimed in claim 1 or 2, wherein each thermal impedance comprises at least one of a thermal resistance and a thermal capacitance.

4. The method as claimed in any of the preceding claims, wherein step a) involves selecting the plurality of geometric entities based on proximity between the physical positions that they represent and the physical position that the at least one geometric entity represents.

5. The method as claimed in claim 4, wherein the proximity is a distance below a threshold value.

6. The method as claimed in any of the preceding claims, wherein the device is a power converter.

7. The method as claimed in any of the preceding claims, repeating steps b) and c) until all estimated temperatures are within an acceptable range compared to the corresponding measured temperature to obtain the composite thermal model (9).

8. The method as claimed in any of the preceding claims, comprising using the composite thermal model (9) for monitoring the electrical machine (6) and the device (8).

9. The method as claimed in any of the preceding claims, wherein the first thermal model (11) and the second thermal models (13) are one of a lumped-parameter thermal network, LPTN, a finite element method model and a finite volume method model.

10. The method as claimed in any of the preceding claims, wherein each geometric entity is one of a node, an edge, a face, and a volume.

11. The method as claimed in any of the preceding claims, comprising obtaining the estimated temperatures based on measured electrical machine operating parameters and device operating parameters provided as inputs to the initial composite thermal model.

12. A computer program comprising computer code which when executed by processing circuitry of a thermal model generator (1) causes the thermal model generator (1) to perform the method of any of the preceding claims.

13. A thermal model generator (1) for generating, from a first thermal model (11) describing the individual thermal behaviour of an electrical machine (6) and a second thermal model (13) describing the individual thermal behaviour of a device (8), a composite thermal model (9) describing the thermal behaviour of a system (4) comprising the electrical machine (6) connected to the device (8), the thermal model generator (1) comprising:
processing circuitry (5), and
a storage medium (7) comprising computer code which when executed by the processing circuitry (5) causes the thermal model generator (1) to perform the method as claimed in any of claims 1-11.

## Patentansprüche

1. Verfahren zum Erzeugen, aus einem ersten thermischen Modell (11), welches das individuelle thermische Verhalten einer Elektromaschine (6) beschreibt, und aus einem zweiten thermischen Modell (13), welches das individuelle thermische Verhalten einer Vorrichtung (8) beschreibt, eines zusammengesetzten thermischen Modells (9), welches das thermische Verhalten eines Systems (4) beschreibt, das die Elektromaschine (6) umfasst, die mit der Vorrichtung (8) verbunden ist, wobei das Verfahren umfasst:
a) Verbinden mindestens einer geometrischen Entität (15, 17, 19) von einem des ersten thermischen Modells (11) und des zweiten thermischen Modells (13) mit einer Vielzahl von geometrischen Entitäten (15, 17, 19) des anderen des ersten thermischen Modells (11) und des zweiten thermischen Modells (13), wobei jede Verbindung mindestens eine von einer Wärmequelle und einer thermischen Impedanz umfasst, wobei das erste thermische Modell (11) und das zweite thermische Modell (13), die miteinander verbunden sind, ein anfängliches zusammengesetztes thermisches Modell bilden,
b) Vergleichen von gemessenen Temperaturen mit entsprechenden geschätzten Temperaturen, die aus dem anfänglichen zusammengesetzten thermischen Modell erhalten werden, und
falls eine geschätzte Temperatur um mehr als einen Schwellenwert von einer gemessenen Temperatur abweicht, c) Anpassen mindestens einer von einer thermischen Impedanz und einer Wärmequelle zwischen einem Paar von geometrischen Entitäten, die im Schritt a) verbunden wurden.

2. Verfahren nach Anspruch 1, wobei im Schritt c) das Anpassen von mindestens einer der thermischen Impedanz und der Wärmequelle erfolgt, die zwischen ein Paar von geometrischen Entitäten (15, 17, 19) geschaltet ist, für das mindestens eine geometrische Entität eine geschätzte Temperatur aufweist, die von der entsprechenden gemessenen Temperatur um mehr als den Schwellenwert abweicht.

3. Verfahren nach Anspruch 1 oder 2, wobei jede thermische Impedanz mindestens einen von einem Wärmewiderstand und einer Wärmekapazität umfasst.

4. Verfahren nach einem der vorhergehenden Ansprüche, wobei Schritt a) ein Auswählen der Vielzahl von geometrischen Entitäten basierend auf einer Nähe zwischen den physischen Positionen, die sie repräsentieren, und den physischen Positionen beinhaltet, welche die mindestens eine geometrische Entität repräsentiert.

5. Verfahren gemäß Anspruch 4, wobei die Nähe ein Abstand unter einem Schwellenwert ist.

6. Verfahren nach einem der vorhergehenden Ansprüche, wobei die Vorrichtung ein Stromrichter ist.

7. Verfahren nach einem der vorhergehenden Ansprüche, das ein Wiederholen der Schritte b) und c) umfasst, bis alle geschätzten Temperaturen innerhalb eines akzeptablen Bereichs im Vergleich zu der entsprechenden gemessenen Temperatur liegen, um das zusammengesetzte thermische Modell (9) zu erhalten.

8. Verfahren nach einem der vorhergehenden Ansprüche, das ein Verwenden des zusammengesetzten thermischen Modells (9) zum Überwachen der Elektromaschine (6) und der Vorrichtung (8) umfasst.

9. Verfahren nach einem der vorhergehenden Ansprüche, wobei das erste thermische Modell (11) und das zweite thermische Modell (13) eines von einem thermischen Netzwerk mit konzentrierten Elementen (Lumped-Parameter Thermal Network, LPTN), einem Modell mit einer Finite-Element-Methode und einem Modell mit einer Finite-Volumen-Methode ist.

10. Verfahren nach einem der vorhergehenden Ansprüche, wobei jede geometrische Entität eine von einem Knoten, einer Kante, einer Fläche und einem Volumen ist.

11. Verfahren nach einem der vorhergehenden Ansprüche, das ein Erhalten der geschätzten Temperaturen basierend auf gemessenen Betriebsparametern der Elektromaschine und gemessenen Betriebsparametern der Vorrichtung umfasst, die als Eingabe für das anfängliche thermische Modell bereitgestellt werden.

12. Computerprogramm, das einen Computercode umfasst, der, wenn er durch eine Verarbeitungsschaltung eines Generators von thermischen Modellen (1) ausgeführt wird, den Generator von thermischen Modellen (1) veranlasst, das Verfahren nach einem der vorhergehenden Ansprüche durchzuführen.

13. Generator von thermischen Modellen (1) zum Erzeugen, aus einem ersten thermischen Modell (11), welches das individuelle thermische Verhalten einer Elektromaschine (6) beschreibt, und aus einem zweiten thermischen Modell (13), welches das individuelle thermische Verhalten einer Vorrichtung (8) beschreibt, eines zusammengesetzten thermischen Modells (9), welches das thermische Verhalten eines Systems (4) beschreibt, das die Elektromaschine (6) umfasst, die mit der Vorrichtung (8) verbunden ist, wobei der Generator von thermischen Modellen (1) umfasst:
eine Verarbeitungsschaltung (5), und
ein Speichermedium (7), das einen Computercode umfasst, der, wenn er durch die Verarbeitungsschaltung (5) ausgeführt wird, den Generator von thermischen Modellen (1) veranlasst, das Verfahren nach einem der Ansprüche 1 bis 11 durchzuführen.

## Revendications

1. Procédé de génération, à partir d'un premier modèle thermique (11) décrivant le comportement thermique individuel d'une machine électrique (6) et d'un second modèle thermique (13) décrivant le comportement thermique individuel d'un dispositif (8), d'un modèle thermique composite (9) décrivant le comportement thermique d'un système (4) comportant la machine électrique (6) reliée au dispositif (8), le procédé comportant les étapes consistant à :
a) connecter au moins une entité géométrique (15, 17, 19) d'un modèle parmi le premier modèle thermique (11) et le second modèle thermique (13) à une pluralité d'entités géométriques (15, 17, 19) de l'autre modèle parmi le premier modèle thermique (11) et le second modèle thermique (13), chaque connexion comportant une source de chaleur et/ou une impédance thermique, le premier modèle thermique (11) et le second modèle thermique (13) connectés l'un à l'autre formant un modèle thermique composite initial,
b) comparer des températures mesurées à des températures estimées correspondantes obtenues à partir du modèle thermique composite initial, et
dans le cas où une température estimée s'écarte de plus d'une valeur seuil par rapport à une température mesurée,
c) ajuster une impédance thermique et/ou une source de chaleur entre une paire d'entités géométriques connectées à l'étape a).

2. Procédé selon la revendication 1, l'ajustement portant à l'étape c) sur l'impédance thermique et/ou la source de chaleur connectées entre une paire d'entités géométriques (15, 17, 19) pour laquelle au moins une entité géométrique présente une température estimée qui s'écarte de plus que la valeur seuil de la température mesurée correspondante.

3. Procédé selon la revendication 1 ou 2, chaque impédance thermique comportant une résistance thermique et/ou une capacitance thermique.

4. Procédé selon l'une quelconque des revendications précédentes, l'étape a) faisant intervenir la sélection de la pluralité d'entités géométriques d'après la proximité entre les positions physiques qu'elles représentent et la position physique que représentent l'entité ou les entités géométriques.

5. Procédé selon la revendication 4, la proximité étant une distance inférieure à une valeur seuil.

6. Procédé selon l'une quelconque des revendications précédentes, le dispositif étant un convertisseur de puissance.

7. Procédé selon l'une quelconque des revendications précédentes, répétant les étapes b) et c) jusqu'à ce que toutes les températures estimées se situent à l'intérieur d'une plage acceptable comparées à la température mesurée correspondante pour obtenir le modèle thermique composite (9) .

8. Procédé selon l'une quelconque des revendications précédentes, comportant l'utilisation du modèle thermique composite (9) pour surveiller la machine électrique (6) et le dispositif (8).

9. Procédé selon l'une quelconque des revendications précédentes, le premier modèle thermique (11) et les seconds modèles thermiques (13) étant d'un type parmi un réseau thermique à paramètres localisés, LPTN, un modèle par méthode d'éléments finis et un modèle par méthode de volumes finis.

10. Procédé selon l'une quelconque des revendications précédentes, chaque entité géométrique étant une entité parmi un nœud, un arc, une face et un volume.

11. Procédé selon l'une quelconque des revendications précédentes, comportant l'obtention des températures estimées d'après des paramètres de fonctionnement mesurés de machine électrique et des paramètres de fonctionnement du dispositif fournis en tant qu'entrées au modèle thermique composite initial.

12. Programme informatique comportant du code informatique qui, lorsqu'il est exécuté par une circuiterie de traitement d'un générateur (1) de modèles thermiques, amène le générateur (1) de modèles thermiques à réaliser le procédé selon l'une quelconque des revendications précédentes.

13. Générateur (1) de modèles thermiques destiné à générer, à partir d'un premier modèle thermique (11) décrivant le comportement thermique individuel d'une machine électrique (6) et d'un second modèle thermique (13) décrivant le comportement thermique individuel d'un dispositif (8), un modèle thermique composite (9) décrivant le comportement thermique d'un système (4) comportant la machine électrique (6) reliée au dispositif (8), le générateur (1) de modèles thermiques comportant : une circuiterie de traitement (5), et
un support (7) de stockage comportant du code informatique qui, lorsqu'il est exécuté par la circuiterie (5) de traitement, amène le générateur (1) de modèles thermiques à réaliser le procédé selon l'une quelconque des revendications 1 à 11.
